# EUROPEAN PATENT SPECIFICATION

(11) **EP 3 575 807 B1**
(45) Date of publication and mention of the grant of the patent: **13.07.2022**
(21) Application number: 19176860.5
(22) Date of filing: 28.05.2019
(51) Int. Cl.: G01R 31/3185, G01R 31/3183, G01R 31/317

(54) **AUTO DETECTION OF JTAG DEBUGGERS/EMULATORS**
AUTOMATISCHE ERKENNUNG VON JTAG-DEBUGGERN/-EMULATOREN
DÉTECTION AUTOMATIQUE DE DÉBOGUEURS/ÉMULATEURS DE JTAG

(30) Priority: 31.05.2018 IN 201811020491
(43) Date of publication of application: 04.12.2019
(73) Proprietor: Hamilton Sundstrand Corporation, Charlotte, NC 28217-4578 (US)
(72) Inventor: KRISHNA, Rajeeva Gopala, 560091 Bangalore-91; Karnataka State (IN); RAO, Sesh Mohan, 560011 Bangalore (IN)
(74) Representative: Dehns

(56) References cited:
- CN-A- 103 902 393
- CN-U- 201 828 797
- CN-Y- 2 888 533
- US-A1- 2009 083 712
- US-A1- 2013 297 974

## Description

### BACKGROUND

The present disclosure relates generally to programming and debugging circuitry, and more specifically to auto detection of JTAG debuggers/emulators.

Debuggers/emulators are used to program, test and resolve defects occurring in computer systems and software. Various techniques are used to verify the designs and perform tests on the various components after manufacture. One technique includes debugging which assists with device, board and system level diagnosis to locate errors and isolate any detected faults. This allows for the testing of the inputs and outputs of various internal blocks of the FPGA/processor without having to disassemble the components to perform tests. For example, these techniques are used to debug software running inside CPUs and are also used to debug digital design blocks of devices such as FPGAs, and microcontrollers. US 2009/0083712 A1 describes a semiconductor integrated circuit including a macro that receives a control signal. US 2013/0297974 A1 describes a processor device with reset condition trace capabilities. CN 201828797 U describes a circuit for preventing resetting of central processing unit in the programming process of a digital signal processor. CN 103902393 A describes a JTAG port safety auxiliary circuit with an external watchdog mechanism. CN 2888533 Y describes a circuit module against fault resetting of SCM.

### BRIEF DESCRIPTION

According to one or more embodiments, methods for auto detection of Joint Test Action Group (JTAG) debuggers/emulators are provided. Methods include sending a reset signal to reset slave devices, detecting a programming signal indicating the slave devices are in a programming/debugging mode, and responsive to the programming signal, inhibiting resetting the slave devices, wherein the slave devices are not on a same JTAG chain. The method is defined by the independent claim 9 and its corresponding dependent claims.

In addition to one or more of the features described above, or as an alternative, further embodiments may include wherein the programming signal is a Test-Reset State (TRST∗) signal and the TRST∗ signal is an active low signal.

In addition to one or more of the features described above, or as an alternative, further embodiments may include wherein a watchdog pulse indicates to the master device that the one or more slave devices are in an active state.

In addition to one or more of the features described above, or as an alternative, further embodiments may include wherein a subsequent reset signal is transmitted responsive to not detecting the watchdog pulse within a fixed interval of time.

In addition to one or more of the features described above, or as an alternative, further embodiments may include wherein the master device and the one or more slave devices are of different technologies.

In addition to one or more of the features described above, or as an alternative, further embodiments may include wherein the master device and the one or more slave devices are of different manufacturers.

In addition to one or more of the features described above, or as an alternative, further embodiments may include implementing a watchdog reset inhibit function where a watchdog reset signal is not transmitted to a reset circuit responsive to detecting the programming signal, wherein the reset circuit is configured to transmit reset signals to the one or more slave devices responsive to the watchdog reset signal.

In addition to one or more of the features described above, or as an alternative, further embodiments may include wherein the master device and one or more slave devices include microcontrollers, processors, DSPs, or FPGAs.

In addition to one or more of the features described above, or as an alternative, further embodiments may include wherein the master device and the one or more slave devices has independent JTAG programming.

In addition to one or more of the features described above, or as an alternative, further embodiments may include wherein the reset signal is an active low signals.

According to another embodiment, systems for auto detection of Joint Test Action Group (JTAG) debuggers/emulators are provided. Systems include a debugger, a master device, wherein the master device is configured to transmit reset signals and detect a programming signal from the debugger, and slave devices, where the slave devices are coupled to the debugger and the master device, wherein the slave devices are not on a same JTAG chain. The system is defined in the independent claim 1 and its corresponding dependent claims.

In addition to one or more of the features described above, or as an alternative, further embodiments may include wherein a reset circuit provides the reset signal to the one or more slave devices responsive to receiving a watchdog reset signal.

In addition to one or more of the features described above, or as an alternative, further embodiments may include a watchdog circuit, wherein the watchdog circuit is coupled to the reset circuit, wherein the watchdog circuit transmits a watchdog reset signal to the reset circuit when a watchdog pulse has not been received within a predetermined time period.

In addition to one or more of the features described above, or as an alternative, further embodiments may include wherein the master device includes watchdog circuit coupled to a reset circuit.

In addition to one or more of the features described above, or as an alternative, further embodiments may include wherein the programming signal is a Test-Reset State (TRST∗) signal and the TRST∗ signal is an active low signal.

In addition to one or more of the features described above, or as an alternative, further embodiments may include wherein a watchdog pulse indicates to the master device that the one or more slave devices are in an active state.

In addition to one or more of the features described above, or as an alternative, further embodiments may include wherein a subsequent reset signal is transmitted responsive to not detecting the watchdog pulse within a fixed interval of time.

In addition to one or more of the features described above, or as an alternative, further embodiments may include implementing a watchdog reset inhibit function where a watchdog reset signal is not transmitted to a reset circuit responsive to detecting the programming signal, wherein the reset circuit is configured to transmit reset signals to the one or more slave devices responsive to the watchdog reset signal.

In addition to one or more of the features described above, or as an alternative, further embodiments may include wherein the master device and the one or more slave devices are of different technologies and/or different manufacturers, and wherein the master device and one or more slave devices include microcontrollers, processors, DSPs, and/or FPGAs.

In addition to one or more of the features described above, or as an alternative, further embodiments may include wherein the master device and the one or more slave devices has independent JTAG programming.

### BRIEF DESCRIPTION OF THE DRAWINGS

The following descriptions should not be considered limiting in any way. With reference to the accompanying drawings, like elements are numbered alike:
FIG. 1 depicts a configuration for operating a master device as a reset hub in accordance with one or more embodiments of the invention;
FIG. 2 depicts another configuration for operating a master device as a monitor in accordance with one or more embodiments of the invention;
FIG. 3 depicts a different configuration including a reset/watchdog circuit in accordance with one or more embodiments of the invention;
FIG. 4 depicts a timing diagram for operating a JTAG debugger/emulator in accordance with one or more embodiments of the invention; and
FIG. 5 depicts a flowchart for auto detection of a JTAG debugger/emulator in accordance with one or more embodiments of the invention.

### DETAILED DESCRIPTION

Various architectures include master and slave devices. The master device can function as a reset hub or a monitor to continuously monitor the slave device(s). In such architectures, individual JTAG interfaces are preferred over daisy chaining.

Also, when these devices are not on the same JTAG chain, challenges arise when programming/debugging the slave device using an external debugger. For example, the master device may not distinguish the entry of the slave device into programming/debugging mode as an acceptable event and may disrupt the programming/debugging operation by constantly resetting the slave device. Other architectures include independent devices, such as DSPs, that interact with an external reset/watchdog monitor circuit.

A watchdog reset inhibit function has to be provided and interlinked with the condition to indicate when either of the two devices are in programming/debugging mode.

The techniques described herein leverage a TRST signal from the IEEE 1149.1 JTAG standard. In one or more embodiments of the invention, a debugger/emulator is configured to program/debug the connected slave devices and apply a TRST pulse to change the mode of the test access point (TAP) Controller to the programming/debugging mode. The master device is configured to detect the TRST pulse applied by the debugger to detect when a slave device will be entering the programming/debugging mode. In addition, the techniques described herein use the TRST∗ (∗ indicates an active low signal) signal to provide a watchdog reset inhibit function when an external reset/watchdog circuit is used to control multiple devices.

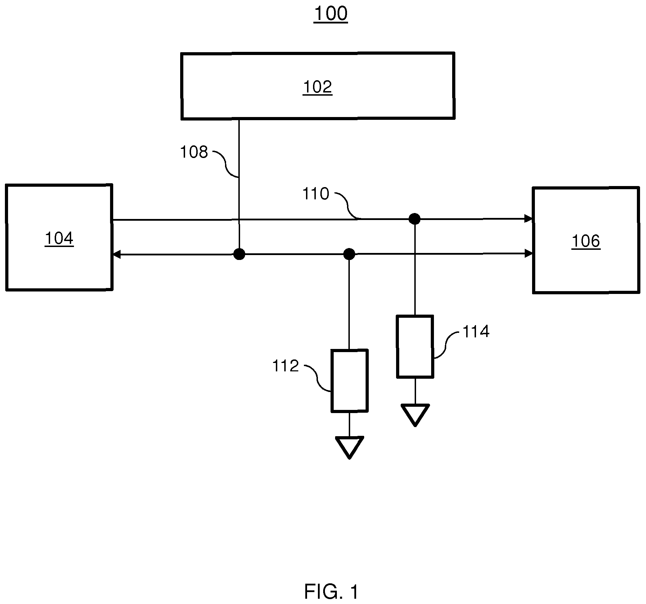

Now referring to FIG. 1, a configuration 100 for auto detection of JTAG debuggers/emulators in accordance with one or more embodiments of the invention is shown. In this configuration 100, the master device 104 functions as a reset hub that controls resetting slave device(s) 106. The configuration 100 also includes a JTAG debugger/emulator 102 where it should be understood that other elements can be included in the configuration. In one or more embodiments of the invention, the master device 104 and slave devices 106 are FPGAs, microcontrollers, processors, DSPs, and the like. In some embodiments wherein the configuration of the master device 104 is functioning in the reset hub architecture, the master device 104 is an FPGA and the slave device 106 is an FPGA, microcontroller, processor, DSP's, etc.

The master device 104 is configured to send a RESET signal 110 to one or more slave devices 106. The RESET signal 110 is pulled down by a resistor 114 to ensure that the slave devices 106 are held in a deterministic initial state. In addition, this prevents the slave devices 106 from being inadvertently placed in a program/debug mode.

When the slave devices 106 are to be programmed, the JTAG debugger/emulator 102 sends a JTAG TRST∗ signal 108 to the slave devices 106 that is detected by the master device 104, which indicates the slave devices 106 are entering the programming/debugging mode. While in the programming/debugging mode, the master device 104 will not disrupt the programming of the slave devices 106 (i.e. will not hold the slave devices 106 in the reset state) by continuously sending the RESET signal 110 responsive to the detection of the TRST∗ signal 108. In other embodiments, the TRST∗ signal is a JCOMP signal, TRSTZ signal, etc. The connection for the TRST∗ signal 108 is pulled down by a pull-down resistor 112, similar to the RESET signal 110, to ensure it is in an initial deterministic state.

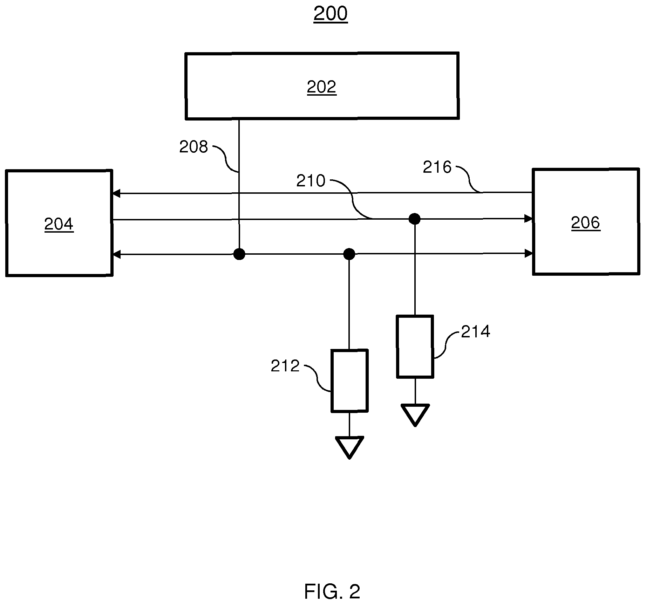

Now referring to FIG. 2, a configuration 200 for auto detection of JTAG debuggers/emulators in accordance with one or more embodiments of the invention is shown. In this configuration 200, the master device 204 is operated to monitor the active state of the coupled slave devices 206 by detecting a watchdog pulse 216 generated from the slave devices 206. In addition, the master device 204 is operated to control the resetting of the slave devices 206 in the event the watchdog pulse 216 is not detected.

The configuration 200 also includes JTAG debugger/emulator 202 where it should be understood that other elements can be included in the configuration. The configuration 200 includes pull-down resistors 212, 214 to hold the connections in a deterministic initial state.

The slave devices 206 are configured to send watchdog signals 216 to the master device 204 to indicate to the master device 204 the slave devices 206 are in an active state. In the event the master device 204 does not detect a watchdog signal 216 from the slave devices 206 within a pre-determined interval of time, the master device 204 sends reset signals 210 to the slave devices 206.

When the slave devices 206 are to be programmed/debugged, the JTAG TRST∗ signal 208 from the JTAG debugger/emulator 202 being transmitted to the slave devices 206 are detected by the master device 204 and indicates the slave device 206 will be entering a programming/debugging mode. Responsive to receiving the TRST∗ signal 208, the master device 204 will not expect to receive the watchdog pulse 216 from the slave devices 206 and will not disrupt the programming of the slave devices 206 (i.e. will not hold the slave device 206 in the reset state).

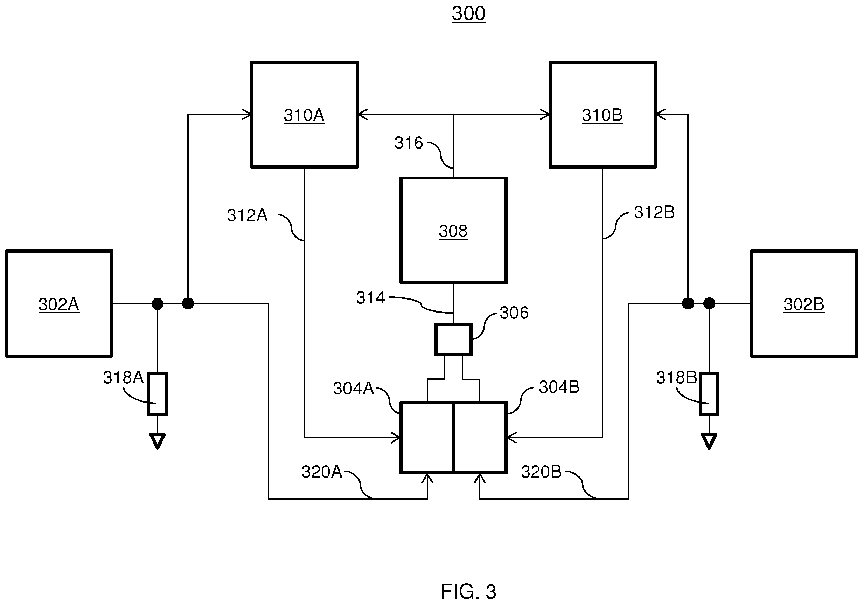

Now referring to FIG. 3, a configuration 300 for auto detection of JTAG debuggers/emulators in accordance with one or more embodiments of the invention is shown. The configuration 300 includes multiple independent devices controlled by external reset and watchdog circuitry.

FIG. 3 includes a JTAG debugger/emulator 302A, 302B that is coupled to the watchdog circuitry 304A, 304B and devices 310A, 310B. The watchdog circuitry 304A, 304B is configured to receive software trigger signals (watchdog pulses) 312A, 312B from devices 310A, 310B and generate WD_Reset signals 314 at a fixed period. In the event the watchdog pulses 312A, 312B are not generated and received within a pre-determined time interval, the watchdog circuitry 304A, 304B sends the WD_Reset signal 314 through a logic gate 306 to the reset circuit 308 to provide a RESET signal 316 to the devices 310A, 310B. In one or more embodiments of the invention the logic gate 306 is an OR gate.

The reset circuit 308 is configured to send a reset signal 316 to the devices 310A, 310B when the watchdog pulses 312A, 312B are not timely received.

In one or more embodiments of the invention, the JTAG TRST∗ signal 320A, 320B can be used by the watchdog circuitry 304A, 304B to inhibit the WD_Reset signal 314, referred to as a watchdog reset inhibit function, when any of the devices 310A, 310B enter a programming or debugging mode. The detection of the TRST∗ signal 320A, 320B prevents the watchdog circuitry 304A, 304B and reset circuit 308 from disrupting the devices 310A, 310B from being disrupted with RESET signals 316 during programming. This holds true in the event the slave devices are DSPs and/or microcontrollers. The pull-down resistors 318A, 318B are configured to hold the signal in a deterministic initial state.

In addition, the devices 310A, 310B are configured to detect the TRST∗ signals 320A, 320B, where upon detection of the TRST∗ signals 320A, 320B the devices 310A, 310B inhibits the transmission of the watchdog pulses 312A, 312B. In other words, during the programming/debugging mode the devices 310A, 310B are unable to generate the watchdog pulses 312A, 312B. The watchdog circuits 304A, 304B, which also detects the TRST∗ signals 320A, 320B, can ignore not receiving the watchdog pulses 312A, 312B and not attempting to reset the devices 310A, 310B because the TRST∗ signals 320A, 320B indicate that they are in the programming/debugging mode.

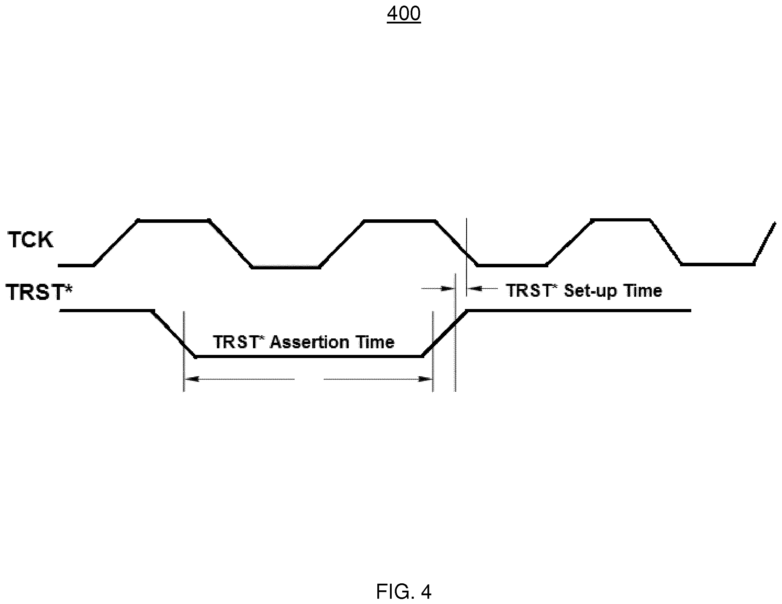

Now referring to FIG. 4, a timing diagram 400 for auto detection of JTAG debuggers/emulators in accordance with one or more embodiments of the invention is shown.

The TRST∗ signal is an active low signal and when low, ensures that the JTAG TAP Controller is held in Test-Reset State and does not interfere with the normal operation of the device. In designs, in order to initialize and place the TAP Controller to Test-Reset State the TRST pin is held low (i.e. pulled to 0V (GND)) using an external pull down resistor.

In order for the debugger to change the mode of the TAP Controller (i.e. entering debug mode for programming) the debugger applies a TRST∗ pulse which goes low and stays high thereafter. In one or more embodiments of the invention, for a given TCK clock, the minimum TRST assertion time required is 100nsec, with minimum setup time of 40nsec.

By detecting the TRST∗ signal provided from a debugger tool, the master device can determine when the slave device is in program/debug mode so the master device does not interrupt the slave device when in that mode.

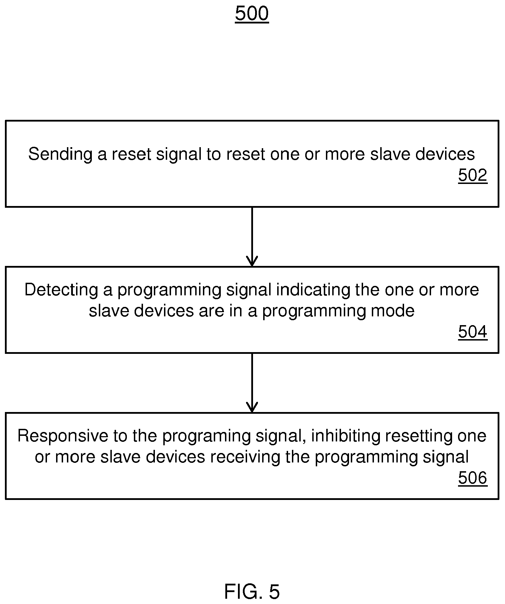

Now referring to FIG. 5, a flow chart 500 for performing auto detection of JTAG debuggers/emulators in accordance with one or more embodiments is shown. Block 502 provides sending a reset signal to one or more slave devices. In embodiments of the invention, a master device is configured to send reset signals to one or more electrically connected slave devices.

Block 504 provides detecting a programming signal indicating the one or more slave devices are in a programming/debugging mode. In one or more embodiments of the invention the programming signal is a TRST∗ signal and is an active low signal. The TRST∗ signal is transmitted from a debugger/emulator tool such as a JTAG debugger to control the slave devices to enter a programming/debugging mode.

Block 506 provides responsive to the programming signal, inhibiting resetting one or more slave devices receiving the programming signal. Embodiments of the invention, include a master device detecting the TRST∗ signal to prevent the master device from disrupting the programming/debugging of the slave devices by continuously sending reset signals. In other embodiments, an external watchdog/reset circuitry can detect the TRST∗ signal to prevent the disruption of the slave devices.

In one or more embodiments of the invention, the TRST signal is from the IEEE 1149.1 JTAG standard which is part of the debugger tool used to program microcontrollers, processors, DSPs or FPGAs.

The technical benefits and effects include overcoming the complexities associated with operating master and slave devices of different technologies, manufacturers and families. In most digital architectures in aerospace, the master and slave devices are chosen to be dissimilar in order to avoid single point of failure. The techniques described herein leverage the JTAG TRST∗ signal to ensure the master device allows the programming/debugging of the slave devices without any disruption. The master and slave devices are configured to have independent programming. In addition, the TRST∗ signal can be used to inhibit the watchdog reset, when an external reset/watchdog circuit to control multiple independent devices.

A detailed description of one or more embodiments of the disclosed apparatus and method are presented herein by way of exemplification and not limitation with reference to the Figures.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

## Claims

1. A system for auto detection of Joint Test Action Group "JTAG" debuggers/emulators, comprising:
a debugger (202);
a master device (204), wherein the master device (204) is configured to transmit reset signals and detect a programming signal from the debugger (202), wherein the programming signal is a Test-Reset State "TRST∗" signal and the "TRST∗ "signal is an active low signal; and
a plurality of slave devices (206), where the slave devices (206) are coupled to the debugger and the master device, wherein the master device (204) and the slave devices (206) have independent JTAG programming; and
**characterized in that** the slave devices (206) are not on a same "JTAG" chain.

2. The system of claim 1, wherein a reset circuit provides the reset signal to the slave devices responsive to receiving a watchdog reset signal

3. The system of claim 2, further comprises a watchdog circuit, wherein the watchdog circuit is coupled to the reset circuit, wherein the watchdog circuit transmits a watchdog reset signal to the reset circuit when a watchdog pulse has not been received within a predetermined time period.

4. The system of claim 3, wherein the master device (204) includes watchdog circuitry coupled to a reset circuit.

5. The system of claim 2, wherein a watchdog pulse indicates to the master device that the slave devices are in an active state.

6. The system of claim 5, wherein a subsequent reset signal is transmitted responsive to not detecting the watchdog pulse within a fixed interval of time.

7. The system of any of claims 1 to 6, further comprises implementing a watchdog reset inhibit function where a watchdog reset signal is not transmitted to a reset circuit responsive to detecting the programming signal, wherein the reset circuit is configured to transmit reset signals to the slave devices (206) responsive to the watchdog reset signal.

8. The system of any of claim 1 to 7, wherein the master device and the slave devices are of different technologies and/or different manufacturers, and wherein the master device (204) and the slave devices include microcontrollers, processors, DSPs, and/or FPGAs.

9. A method for auto detection of Joint Test Action Group "JTAG" debuggers/emulators using the system of claims 1 to 8, comprising:
sending a reset signal to reset the slave devices (206);
detecting a programming signal indicating the slave devices are in a programming/debugging mode; and
responsive to the programming signal, inhibiting resetting the slave devices receiving the programming signal, wherein the programming signal is a Test-Reset State "TRST∗" signal and the "TRST∗" signal is an active low signal.

10. The method of claim 9, wherein a watchdog pulse indicates to the master device that the slave devices (206) are in an active state

11. The method of claim 10, wherein a subsequent reset signal is transmitted responsive to not detecting the watchdog pulse within a fixed interval of time.

12. The method of any of claims 9 to 11, further comprises implementing a watchdog reset inhibit function where a watchdog reset signal is not transmitted to a reset circuit responsive to detecting the programming signal, wherein the reset circuit is configured to transmit reset signals to the slave devices responsive to the watchdog reset signal.

13. The method of any of claims 9 to 12, wherein the master device (204) and the slave devices are of different technologies.

14. The method of any of claims 9 to 12, wherein the master device (204) and the slave devices (206) include microcontrollers, processors, DSPs or FPGAs.

15. The method of any of claims 9 to 12, wherein the master device (204) and the slave devices (206) have independent JTAG programming.

## Patentansprüche

1. System zur automatischen Erkennung von Debuggern/Emulatoren der Joint Test Action Group "JTAG", umfassend:
einen Debugger (202);
eine Master-Vorrichtung (204), wobei die Master-Vorrichtung (204) so konfiguriert ist, dass sie Reset-Signale überträgt und ein Programmiersignal von dem Debugger (202) erfasst, wobei das Programmiersignal ein Test-Reset-Status-"TRST*"-Signal ist und das "TRST*"-Signal ein aktives Low-Signal ist; und
eine Vielzahl von Slave-Vorrichtungen (206), wobei die Slave-Vorrichtungen (206) mit dem Debugger und der Master-Vorrichtung gekoppelt sind, wobei die Master-Vorrichtung (204) und die Slave-Vorrichtungen (206) eine unabhängige JTAG-Programmierung aufweisen; und
**dadurch gekennzeichnet, dass** sich die Slave-Vorrichtungen (206) nicht auf derselben "JTAG"-Kette befinden.

2. System nach Anspruch 1, wobei eine Reset-Schaltung das Reset-Signal an die Slave-Vorrichtungen als Reaktion auf den Empfang eines Watchdog-Reset-Signals bereitstellt.

3. System nach Anspruch 2, ferner umfassend eine Watchdog-Schaltung, wobei die Watchdog-Schaltung mit der Reset-Schaltung gekoppelt ist, wobei die Watchdog-Schaltung ein Watchdog-Reset-Signal an die Reset-Schaltung sendet, wenn ein Watchdog-Impuls nicht innerhalb einer vorbestimmten Zeitspanne empfangen worden ist.

4. System nach Anspruch 3, wobei die Master-Vorrichtung (204) eine Watchdog-Schaltung beinhaltet, die mit einer Reset-Schaltung gekoppelt ist.

5. System nach Anspruch 2, wobei ein Watchdog-Impuls der Master-Vorrichtung anzeigt, dass sich die Slave-Vorrichtungen in einem aktiven Zustand befinden.

6. System nach Anspruch 5, wobei ein nachfolgendes Reset-Signal als Reaktion darauf übertragen wird, dass der Watchdog-Impuls nicht innerhalb eines festen Zeitintervalls erfasst wird.

7. System nach einem der Ansprüche 1 bis 6, ferner umfassend Implementieren einer Watchdog-Reset-Sperrfunktion, bei der ein Watchdog-Reset-Signal als Reaktion auf das Erfassen des Programmiersignals nicht an eine Reset-Schaltung übertragen wird, wobei die Reset-Schaltung so konfiguriert ist, dass sie als Reaktion auf das Watchdog-Reset-Signal Reset-Signale an die Slave-Vorrichtungen (206) überträgt.

8. System nach einem der Ansprüche 1 bis 7, wobei die Master-Vorrichtung und die Slave-Vorrichtungen aus unterschiedlichen Technologien und/oder von unterschiedlichen Herstellern stammen und wobei die Master-Vorrichtung (204) und die Slave-Vorrichtungen Mikrocontroller, Prozessoren, DSP und/oder FPGA beinhalten.

9. Verfahren zur automatischen Erfassung von Debuggern/Emulatoren der Joint Test Action Group "JTAG" unter Verwendung des Systems der Ansprüche 1 bis 8, umfassend:
Senden eines Reset-Signals zum Zurücksetzen der Slave-Vorrichtungen (206);
Erfassen eines Programmiersignals, das anzeigt, dass sich die Slave-Vorrichtungen in einem Programmier-/Debuggingmodus befinden; und
als Reaktion auf das Programmiersignal Sperren des Zurücksetzens der Slave-Vorrichtungen, die das Programmiersignal empfangen, wobei das Programmiersignal ein Test-Reset-Zustands-"TRST*"-Signal ist und das "TRST*"-Signal ein aktives Low-Signal ist.

10. Verfahren nach Anspruch 9, wobei ein Watchdog-Impuls der Master-Vorrichtung anzeigt, dass sich die Slave-Vorrichtungen (206) in einem aktiven Zustand befinden.

11. Verfahren nach Anspruch 10, wobei ein nachfolgendes Reset-Signal als Reaktion darauf übertragen wird, dass der Watchdog-Impuls nicht innerhalb eines festen Zeitintervalls erfasst wird.

12. Verfahren nach einem der Ansprüche 9 bis 11, ferner umfassend Implementieren einer Watchdog-Reset-Sperrfunktion, bei der ein Watchdog-Reset-Signal als Reaktion auf das Erfassen des Programmiersignals nicht an eine Reset-Schaltung übertragen wird, wobei die Reset-Schaltung so konfiguriert ist, dass sie als Reaktion auf das Watchdog-Reset-Signal Reset-Signale an die Slave-Vorrichtungen überträgt.

13. Verfahren nach einem der Ansprüche 9 bis 12, wobei die Master-Vorrichtung (204) und die Slave-Vorrichtungen aus unterschiedlichen Technologien stammen.

14. Verfahren nach einem der Ansprüche 9 bis 12, wobei die Master-Vorrichtung (204) und die Slave-Vorrichtungen (206) Mikrocontroller, Prozessoren, DSP oder FPGA beinhalten.

15. Verfahren nach einem der Ansprüche 9 bis 12, wobei die Master-Vorrichtung (204) und die Slave-Vorrichtungen (206) eine unabhängige JTAG-Programmierung aufweisen.

## Revendications

1. Système de détection automatique de débogueurs/émulateurs de Joint Test Action Group « JTAG », comprenant :
un débogueur (202) ;
un dispositif maître (204), dans lequel le dispositif maître (204) est configuré pour transmettre des signaux de réinitialisation et détecter un signal de programmation provenant du débogueur (202), dans lequel le signal de programmation est un signal d'état de réinitialisation de test « TRST* » et le signal « TRST* » est un signal bas actif ; et une pluralité de dispositifs esclaves (206), les dispositifs esclaves (206) étant couplés au débogueur et au dispositif maître, dans lequel le dispositif maître (204) et les dispositifs esclaves (206) ont une programmation JTAG indépendante ; et
**caractérisé en ce que** les dispositifs esclaves (206) ne sont pas sur une même chaîne « JTAG ».

2. Système selon la revendication 1, dans lequel un circuit de réinitialisation fournit le signal de réinitialisation aux dispositifs esclaves en réponse à la réception d'un signal de réinitialisation de surveillance.

3. Système selon la revendication 2, comprenant en outre un circuit de surveillance, dans lequel le circuit de surveillance est couplé au circuit de réinitialisation, dans lequel le circuit de surveillance transmet un signal de réinitialisation de surveillance au circuit de réinitialisation lorsqu'une impulsion de surveillance n'a pas été reçue dans un délai prédéterminé.

4. Système selon la revendication 3, dans lequel le dispositif maître (204) comporte un circuit de surveillance couplé à un circuit de réinitialisation.

5. Système selon la revendication 2, dans lequel une impulsion de surveillance indique au dispositif maître que les dispositifs esclaves sont dans un état actif.

6. Système selon la revendication 5, dans lequel un signal de réinitialisation ultérieur est transmis en réponse à la non-détection de l'impulsion de surveillance dans un intervalle de temps fixe.

7. Système selon l'une quelconque des revendications 1 à 6, comprenant en outre la mise en œuvre d'une fonction d'inhibition de réinitialisation de surveillance dans laquelle un signal de réinitialisation de surveillance n'est pas transmis à un circuit de réinitialisation en réponse à la détection du signal de programmation, dans lequel le circuit de réinitialisation est configuré pour transmettre des signaux de réinitialisation aux dispositifs esclaves (206) répondant au signal de réinitialisation de surveillance.

8. Système selon l'une quelconque des revendications 1 à 7, dans lequel le dispositif maître et les dispositifs esclaves sont de technologies différentes et/ou de fabricants différents, et dans lequel le dispositif maître (204) et les dispositifs esclaves comportent des microcontrôleurs, des processeurs, des DSP et/ou des FPGA.

9. Procédé de détection automatique de débogueurs/émulateurs de Joint Test Action Group « JTAG » utilisant le système des revendications 1 à 8, comprenant :
l'envoi d'un signal de réinitialisation pour réinitialiser les dispositifs esclaves (206) ;
la détection d'un signal de programmation indiquant que les dispositifs esclaves sont dans un mode de programmation/débogage ; et
en réponse au signal de programmation, l'inhibition de la réinitialisation des dispositifs esclaves recevant le signal de programmation, dans lequel le signal de programmation est un signal d'état de réinitialisation de test « TRST* » et le signal « TRST* » est un signal bas actif.

10. Procédé selon la revendication 9, dans lequel une impulsion de surveillance indique au dispositif maître que les dispositifs esclaves (206) sont dans un état actif.

11. Procédé selon la revendication 10, dans lequel un signal de réinitialisation ultérieur est transmis en réponse à la non-détection de l'impulsion de surveillance dans un intervalle de temps fixe.

12. Procédé selon l'une quelconque des revendications 9 à 11, comprenant en outre la mise en œuvre d'une fonction d'inhibition de réinitialisation de surveillance dans laquelle un signal de réinitialisation de surveillance n'est pas transmis à un circuit de réinitialisation en réponse à la détection du signal de programmation, dans lequel le circuit de réinitialisation est configuré pour transmettre des signaux de réinitialisation aux dispositifs esclaves répondant au signal de réinitialisation de surveillance.

13. Procédé selon l'une quelconque des revendications 9 à 12, dans lequel le dispositif maître (204) et les dispositifs esclaves sont de technologies différentes.

14. Procédé selon l'une quelconque des revendications 9 à 12, dans lequel le dispositif maître (204) et les dispositifs esclaves (206) comportent des microcontrôleurs, des processeurs, des DSP ou des FPGA.

15. Procédé selon l'une quelconque des revendications 9 à 12, dans lequel le dispositif maître (204) et les dispositifs esclaves (206) ont une programmation JTAG indépendante.
